# EUROPEAN PATENT SPECIFICATION

(11) **EP 0 582 329 B1**
(45) Date of publication and mention of the grant of the patent: **10.10.2001**
(21) Application number: 93202071.2
(22) Date of filing: 16.07.1993
(51) Int. Cl.: G01R 27/22

(54) **Device for measuring the water resistivity in a washing machine**
Widerstandsmessanordnung für das Wasser in einer Waschmachine
Dispositif pour mesurer la résistance de l'eau dans une machine à laver

(30) Priority: 03.08.1992 IT TO920668
(43) Date of publication of application: 09.02.1994
(73) Proprietor: WRAP S.p.A., 60044 Fabriano (AN) (IT)
(72) Inventor: Aisa, Valerio, I-60044 Fabriano (AN) (IT); Bongini, Dino, I-60044 Fabriano (AN) (IT); Lattanzi, Giuseppe, I-60044 Fabriano (AN) (IT); Mariotti, Costantino, I-06028 Sigillo (PG) (IT)
(74) Representative: Dini, Roberto, Dr. Ing.

(56) References cited:
- EP-A- 0 010 823
- DE-A- 3 436 421
- FR-A- 2 289 907

## Description

The present invention refers to a device, and relevant methods, for measuring characteristic of the water used in a washing machine, in particular a laundry washing machine, comprising a washing chamber.

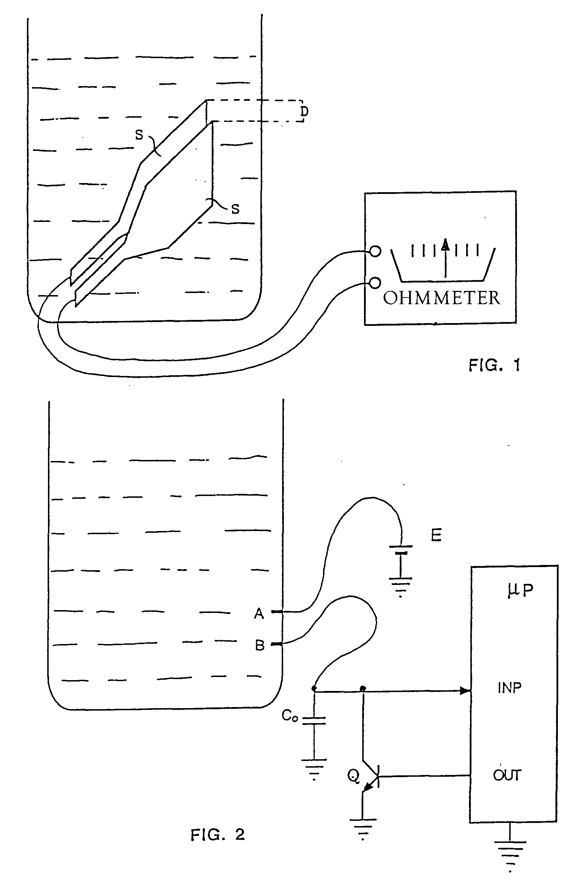

It is known that the electric resistivity of a liquid may be deduced by measuring the value of the electric resistance between two electrodes immersed in the liquid. Such measurement may be for example carried out utilising two electrodes immersed in the liquid, being flat disposed and parallel to each other, having equal surface areas S and arranged at a distance D one from the other (see figure 1) and measuring the resistance R opposite the path of the current of the liquid interposed between the electrodes.

The resistivity r (that is the inverse of the conductivity) will be in that case theoretically provided with the formula:
r = R/(S*D) in ohm/cm³, i.e. it will be equal to the measured resistance divided by the volume between the electrodes.

To carry out precise measurements on a wide field of values it is however in practice necessary to carry out a long series of measurements, varying the surface area and the mutual distance of the electrodes and changing the scale of the measuring instrument.

In the specific case of a washing machine for domestic use. due to reasons of cost, it is not possible to utilise sensors with variable configuration and sophisticated instruments (ohmmeter of numerous scales), whereupon it becomes practically impossible to control wide resistivity values with inexpensive sensors and measuring instruments.

In washing-machines, in particular in laundry washing machines, the problem arises that the value of the resistivity of the washing water can vary in very wide limits, from a few megaohm/cm³ (water with a very low level of hardness) to a few ohm/cm³ (water with detergent just dissolved), whereupon the attempt to utilise inexpensive traditional solutions appears to be impractical for carrying out an effective monitorisation of said quantity.

Considering that during the washing phase the resistivity value and its dynamics of variation over time can supply interesting indications as to the soil quantity, to the state of the actual washing process, to the hardness of the water withdrawn from the water mains, to the concentration of detergents, the utility of an inexpensive device that allows to control such quantities appears evident.

In fact washing machines have been proposed equipped with a turbidity sensor, based on an optical system, i.e. on the greater or minor transparency of the liquid; such machines provide light emitting diodes, phototransistors, power constant sources with width pulse modulators, and memory receiving circuits (note for example Japanese Patent Application no. J02213396).

From EP-A-0 010 823 an apparatus is known, for measuring electrical conductivity, particularly with the purpose of detecting mastitis in individual quarters of a cow's udder; the apparatus provides for the cyclical charge and discharge of a capacitor through milk in a conductivity cell under static conditions, the cycle reversing on the potential applied to the capacitor reading a high reference potential and a low reference potential by applying the reference potentials to terminals or sensing leads of electronic devices, or to cause operation of switches so that the variations in frequency are indications of conductivity of the cell.

The aim of the present invention is that of illustrating how it is possible to realise, with extremely contained costs, a device for measuring the water resistivity in a washing machine during the phases of the washing process, in particular for measuring the degree of soil in order to control the washing procedure or for measuring the water hardness in order to establish the dosage of the detergents and of eventual agents that reduce the hardness (Calfort® ), or further for measuring the level of the concentration of detergents, in order to favour its automatic dosage and, during the rinsing phase, the elimination thereof.

For achieving such aims the present invention has as its subject the measuring method having the characterizing features of the annexed claims 1, 2 and 3, and a washing machine comprising a measuring device having the characterizing features of the annexed claim 5.

Further aims and advantages of the present invention will result in being clear from the detailed description that follows and from the annexed drawings, supplied purely as an explanatory and non-limiting example, wherein:
figure 1 represents the diagram of the fundamentals of a device for measuring the resistivity of a liquid;
figure 2 represents the diagram of the fundamentals of the measuring device according to the invention;
figure 3 represents the case of the device applied in union with a chamber in a metallic material;
figure 4 represents the case of the device applied in union with a chamber in an insulating material;
figure 5 represents the case of a more general usage;
figure 6 represents a partially sectioned schematic view of the underside of a washing-machine incorporating a preferred version of the device according to the invention.

The invention is based on the acknowledgement of the fact that, from exhaustive practical tests carried out, it is shown that the charging time of a capacitor, within the charge circuit of which two electrodes are inserted, immersed in the washing water, results in being substantially proportional to the resistivity of the water.

With regards to Figure 2, in which the diagram of the fundamentals of the measuring device according to the invention is represented, with reference symbols A and B two electrodes immersed in the washing water of the machine are shown; with the symbol E a source of continuous electric voltage is shown (battery or accumulator or feeder), connected between the electrical bonding of the electronic measuring circuit and the electrode A; with the symbol Co a capacitor is shown, connected to the electrode B and the electrical bonding; with the symbol Q a transistor is shown, the sender-collector section of which is connected in parallel to the capacitor Co; with the symbol INP an input terminal is shown of a microcontroller (indicated in turn with the symbol µP), such terminal is connected to the armature of the capacitor Co connected to the electrode B; finally with the symbol OUT an output terminal of the same microcontroller is shown, connected to the base of the transistor Q.

For carrying out the measurements the microcontroller initially discharges the capacitor Co, sending, by way of the output terminal OUT, an impulse, of opportune polarity and duration, on the base of the transistor Q, used as a switch.

Therefore the microcontroller, as soon as it has discharged the capacitor, begins a count of the elapsed time, until, by way of the input terminal INP, it has detected that the capacitor Co has reached a determined voltage charge. In particular, the microcontroller, after having discharged the capacitor and enabled its new charging, will start the count of the time which passes from the beginning of the actual charge and the reaching of a determined voltage at the terminals of the capacitor Co; such voltage, if directly applied to the input INP of the microcontroller (as indicated in figure 2), will correspond to approximately half the supply voltage of the actual microcontroller (which is generally of 5V). On the other hand, in the case in which a greater precision of the comparison threshold is desired of the charge voltage of the capacitor, the threshold could be applied to the input of an appropriate voltage comparator having the output connected to the same input INP of the microcontroller.

Said charging time measured by the microcontroller will be referred to as Tc .

It is to be noted that electrolysis problems do not exist, given that there is circulation of current in the water only during the time of charging; furthermore the energy in involved during each charge is minimum, if the capacity of the capacitor Co is selected appropriately low.

The value of the capacity of the capacitor Co must however be selected in a such a way that the time of charging Tc does not assume values being excessively small (and therefore difficult to measure exactly) in conditions of minimum water resistivity.

Furthermore it is necessary to also take into account the geometric characteristics of the sensor, i.e. its shape and relative distance of electrodes A and B that define electric parameters.

Resistance values between the two electrodes may normally vary from a few ohm to a few megaohm and, also considering that the inexpensive microcontrollers existing in trade are able to discriminate times with resolutions lower than a microsecond, a suitable capacity value for the capacitor Co may be of about 1 microfarad.

In fact, for example:
Co =1 microfarad;
max. resistance (for a given pair of electrodes) = 1 megaohm;
min. resistance (for the same pair of electrodes) = 10 ohm;
Tc = R*Co and therefore:
   Tc max = 1 second;
   Tc min = 10 microseconds.

Assuming that the microcontroller has a time resolution of 1 microsecond, it would result that Tc max corresponds to a million cycles, and Tc min ten cycles, with resolution still being sufficient.

It therefore appears clear that it is possible with the arrangement according to the invention, to carry out, with minimum costs (the microcontroller may cost a dollar), a resistivity measurement with good resolution in a very wide field of values.

With the aid of an intelligent control system and applying programming rules of the microcontroller of the "fuzzy logic" type, the resistivity sensor does not require particular characteristics.

The important thing is not so much the absolute value of the measure and its repeatability, rather its relative value in function with the washing characteristics.

It is therefore sufficient that the sensor has only a good sensitivity, being improved thanks to an equally good resolution of the measuring apparatus (microcontroller) .

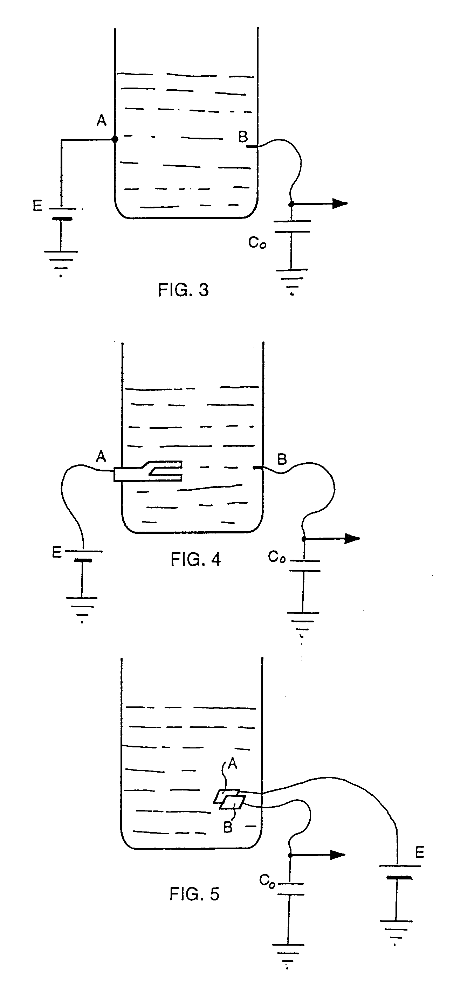

In the Figures 3, 4 and 5 three examples of sensors are represented, applicable to a laundry washing machine: figure 3 represents the case of a washing-machine with a stainless steel chamber; the electrode A is constituted by the stainless steel chamber; the electrode B is constituted by a stainless steel commercial sensor inserted in the chamber with the assistance of an appropriate seal (utilising, for example, the hole of a fixed electromechanic type thermostat) .

Figure 4 represents the case of a chamber in enamelled steel or in plastic material; the electrode A may in this case be associated to an appropriate conductor element already present in the chamber, for example the metallic body of the water heating resistance; the electrode B may be realised as in the example of figure 3.

Figure 5 represents a more general case, with an expressly built sensor, characterised by two conducting blades (electrodes A and B), duly shaped and spaced apart.

The characteristics of the described measuring device are clear from the present description and annexed drawings.

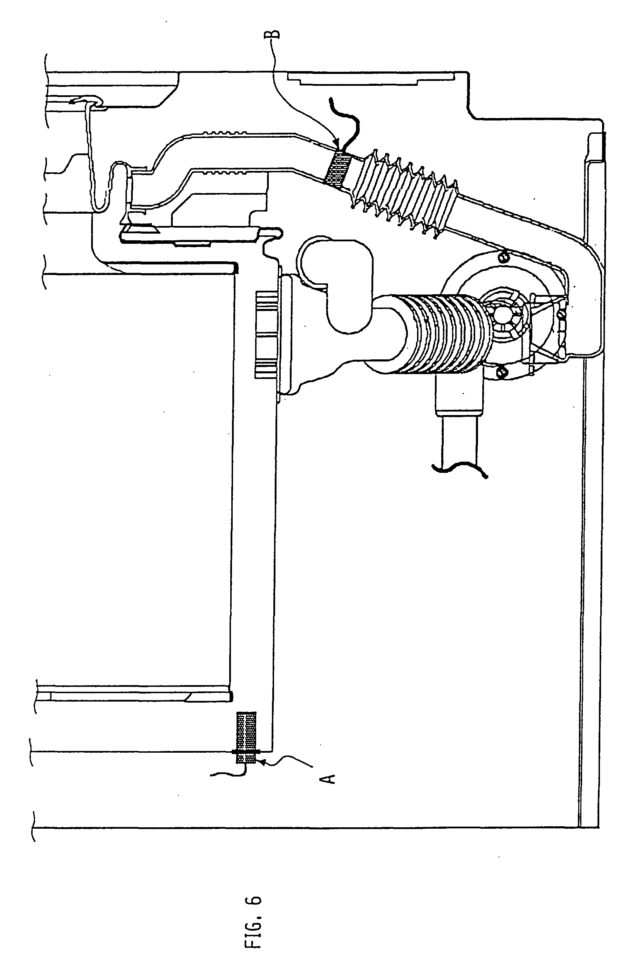

In figure 6 a partially sectioned schematic view of the underside of a washing-machine is represented incorporating a preferred version of the device according to the invention.

The relative position of the electrodes compared to the different metallic parts (chamber and basket) of a washing-machine, in particular a laundry washing machine, is determining; so as to extract the maximum information concerning the chemical state of the water it is in fact opportune that the path of the current, that flows from electrode A to electrode B, is effectively carried out for the maximum part in water, something that does not take place if at least one of the two electrodes (B, fig. 6) not is duly insulated and physically spaced from metallic parts of the machine.

A position of the electrodes has experimentally been found that is satisfactory and can also be easily obtained considering the practical realisation viewpoint. It concerns utilising as electrode A a metallic body inserted in a hole of the chamber and insulated with an appropriate seal (for example the body of the water temperature sensor), or, easier still, any metallic element of the chamber-drum group which is in conctact with the washing liquid (for instance any point connected to the earth of the machine). As a second electrode the utilisation has been revealed adequate of a metallic joint between two rubber tubes of the so-called recovery zone of the detergents, arranged in the lower part of the machine; in such a way the current creates a sufficiently long path in the water, in virtue of the isolation of said tubes from the other metallic parts. sufficiently long path in the water, in virtue of the isolation of said tubes from the other metallic parts.

An example of the arrangement of the electrodes A and B according to the criteria mentioned is in fact illustrated in figure 6.

One could also think of utilising a third additional electrode in another position, different from where the electrode B is to be found, for obtaining a simultaneous and parallel detection of two values of conductivity, having in common electrode A as a source; one could in such way increase in a significant measure the quantity of information obtainable, at an insignificant additional cost.

From the present description the practical advantages of the measuring device object of the present invention are also clear.

In particular the described device allows for obtaining with very contained costs, resistivity measures with a good resolution in a very wide range of values.

This allows to obtain devices for measuring of the degree of soil or of the water hardness or of the concentration of detergents that can easily find applications in washing machines: laundry washing machines, dishwashing machines or others.

For instance, in the case of a dishwashing machine, the device subject of the present invention could be used for controlling the efficiency of the resins which reduce water hardness. In such an application, the control of the resins operation is realised with the described device, by measuring the differential conductivity between the incoming water (mains water) and the exiting water (softened water): in this way it is possible to carry out the regenerating cycle only when necessary, so as to avoid an excessive salt consumption.

It is clear that numerous variations are possible by the skilled-man, to the device or to the washing machine described as an example, without departing from the novelty principles inherent in the invention; all the components indicated can naturally be replaced with technical equivalents.

## Claims

1. Method for measuring, during a washing process, the hardness of the washing liquid used in a washing machine, said machine comprising a washing chamber and a measuring device comprising at least a first and a second electrode (A,B) in contact with water, the method being **characterized by** the following steps:
a) providing said electrodes (A,B) in contact with the washing liquid and in the charge circuit of a capacitor (Co);
b) discharging said capacitor (Co);
c) causing a flow of current within the washing liquid between said electrodes (A,B), for charging said capacitor (Co);
d) measuring the charge time of the capacitor (Co);
e) determining the value of the hardness of the washing liquid in an indirect manner, in function of:
- the time needed for charging said capacitor (Co) through said flow of current,
- the characteristic of the washing process.

2. Method for measuring, during a washing process, the degree of soil of the washing liquid used in a washing machine, said machine comprising a washing chamber and a measuring device comprising at least a first and a second electrode (A,B) in contact with water, the method being **characterized by** the following steps:
a) providing said electrodes (A,B) in contact with the washing liquid and in the charge circuit of a capacitor (Co);
b) discharging said capacitor (Co);
c) causing a flow of current within the washing liquid between said electrodes (A,B), for charging said capacitor (Co);
d) measuring the charge time of the capacitor (Co);
e) determining the value of the degree of soil of the washing liquid in an indirect manner, in function of:
- the time needed for charging said capacitor (Co) through said flow of current,
- the characteristic of the washing process.

3. Method for measuring, during a washing process, the detergent concentration in the washing liquid used in a washing machine, said machine comprising a washing chamber and a measuring device comprising at least a first and a second electrode (A,B) in contact with water, the method being **characterized by** the following steps:
a) providing said electrodes (A,B) in contact with the washing liquid and in the charge circuit of a capacitor (Co);
b) discharging said capacitor (Co);
c) causing a flow of current within the washing liquid between said electrodes (A,B), for charging said capacitor (Co);
d) measuring the charge time of the capacitor (Co);
e) determining the value of the detergent concentration in the washing liquid in an indirect manner, in function of:
- the time needed for charging said capacitor (Co) through said flow of current,
- the characteristic of the washing process.

4. Method, according to claim 1 or 2 or 3, **characterized in that** at least steps d) and e) are carried out by a microcontroller (µP) programmed in accordance with the fuzzy logic techniques.

5. Washing machine, in particular a laundry washing machine, comprising a washing chamber and a device for measuring characteristics of the washing water during a washing process, such as the degree of soil in the water, the water hardness, the detergent concentration in the water, **characterized in that** said device comprises:
- at least two electrodes (A,B) in contact with the washing water and inserted in the charge circuit of a capacitor (Co);
- means for discharging said capacitor (Co).
- means (E) for causing, during a phase of a washing process, a flow of current within said washing water between said electrodes (A,B), which charges said capacitor (Co);
- means (µP) for measuring the time needed for charging said capacitor (Co) through said flow of current;
- means (µP) for calculating in an indirect manner, in function of time needed for charging said capacitor (Co) through said flow of current and in function of the characteristics of the washing process, the water resistivity and for measuring therefrom the desired water characteristic.

6. Washing machine, according to claim 5, **characterized in that** said measuring means comprise a microcontroller (µP).

7. Washing machine, according to claim 5, **characterized in that** said calculating and measuring means comprise a microcontroller (µP).

8. Washing machine, according to claim 6 or 7, **characterized in that** said microcontroller (µP) is programmed in accordance with the fuzzy logic techniques.

9. Washing machine, according to claim 5, **characterized in that** said means for discharging said capacitor (Co) comprise a transistor (Q).

10. Washing machine, according to claim 6 or 7, **characterized in that** said microcontroller (µP) provides an input terminal (INP) connected to an armature of said capacitor (Co), and an output terminal (OUT).

11. Washing machine, according to claims 9 and 10, **characterized in that** said output terminal (OUT) is connected to the control electrode of said transistor (Q).

12. Washing machine, according to claim 5, **characterized in that** one of said electrodes (A) is constituted by the metallic chamber of the washing machine, or by a water heating resistor or by the body of a water temperature sensor.

13. Washing machine, according to claim 5, **characterized in that** at least one of said electrodes (B) is electrically insulated and physically spaced from the metallic parts of the washing machine and from the other electrode (A).

14. Washing machine, according to claim 5, **characterized in that** a third electrode (C) is provided, being arranged far from both of the two said electrodes (A,B).

15. Washing machine, according to claim 5, **characterized in that** one of said electrodes (B) is constituted by a metallic joint inserted between two flexible tubes in electrically insulated material making up part of a detergent recovery circuit.

## Patentansprüche

1. Verfahren zum Messen der Härte der in einer Waschmaschine benutzten Waschflüssigkeit während eines Waschvorgangs, bei dem die Waschmaschine eine Waschkammer und eine Messvorrichtung, welche wenigstens eine erste und eine zweite in Kontakt mit Wasser befindliche Elektrode (A, B) aufweist, umfasst, wobei das Verfahren durch die folgenden Schritte gekennzeichnet ist:
a) Anordnung der Elektroden (A, B) in Kontakt mit der Waschflüssigkeit und im Ladekreis eines Kondensators (Co);
b) Entladen des Kondensators (Co);
c) Erzeugen eines Stromflusses innerhalb der Waschflüssigkeit zwischen den Elektroden (A, B) zur Ladung des Kondensators (Co);
d) Messen der Ladezeit des Kondensators (Co);
e) Bestimmen des Härtewerts der Waschflüssigkeit in indirekter Weise als Funktion von:
- der Zeit, welche benötigt wird, um den Kondensator (Co) mittels des Stromflusses zu laden,
- der Charakteristik des Waschvorgangs.

2. Verfahren zum Messen des Verschmutzungsgrads der in einer Waschmaschine benutzten Waschflüssigkeit während eines Waschvorgangs, bei dem die Waschmaschine eine Waschkammer und eine Messvorrichtung, welche wenigstens eine erste und eine zweite in Kontakt mit Wasser befindliche Elektrode (A, B) aufweist, umfasst, wobei das Verfahren durch die folgenden Schritte gekennzeichnet ist:
a) Anordnung der Elektroden (A, B) in Kontakt mit der Waschflüssigkeit und im Ladekreis eines Kondensators (Co);
b) Entladen des Kondensators (Co);
c) Erzeugen eines Stromflusses innerhalb der Waschflüssigkeit zwischen den Elektroden (A, B) zur Ladung des Kondensators (Co);
d) Messen der Ladezeit des Kondensators (Co);
e) Bestimmen des Werts des Verschmutzungsgrads der Waschflüssigkeit in indirekter Weise als Funktion von:
- der Zeit, welche benötigt wird um den Kondensator (Co) mittels des Stromflusses zu laden,
- der Charakteristik des Waschvorgangs.

3. Verfahren zum Messen der Waschmittelkonzentration der in einer Waschmaschine benutzten Waschflüssigkeit während eines Waschvorgangs, bei dem die Waschmaschine eine Waschkammer und eine Messvorrichtung, welche wenigstens eine erste und eine zweite in Kontakt mit Wasser befindliche Elektrode (A, B) aufweist, umfasst, wobei das Verfahren durch die folgenden Schritte gekennzeichnet ist:
a) Anordnung der Elektroden (A, B) in Kontakt mit der Waschflüssigkeit und im Ladekreis eines Kondensators (Co);
b) Entladen des Kondensators (Co);
c) Erzeugen eines Stromflusses innerhalb der Waschflüssigkeit zwischen den Elektroden (A, B) zur Ladung des Kondensators (Co);
d) Messen der Ladezeit des Kondensators (Co);
e) Bestimmen des Werts der Waschmittelkonzentration in der Waschflüssigkeit in indirekter Weise als Funktion von:
- der Zeit, welche benötigt wird um den Kondensator (Co) mittels des Stromflusses zu laden,
- der Charakteristik des Waschvorgangs.

4. Verfahren nach Anspruch 1, 2 oder 3,
**dadurch gekennzeichnet, dass** wenigstens die Schritte d) und e) durch eine fuzzy-logic-programmierte Mikrosteuerung ausgeführt werden.

5. Waschmaschine, insbesondere eine Großwaschmaschine, umfassend eine Waschkammer und eine Vorrichtung zum Messen von Eigenschaften des Waschwassers während eines Waschvorgangs, wie den Verschmutzungsgrad im Wasser, die Wasserhärte, die Waschmittelkonzentration im Wasser,
**dadurch gekennzeichnet, dass** die Vorrichtung umfasst:
- Wenigstens zwei Elektroden (A, B) in Kontakt mit dem Waschwasser und in den Ladekreislauf eines Kondensators (Co) eingesetzt;
- Mittel zum Entladen des Kondensators (Co);
- Mittel (E) zum Erzeugen eines Stromflusses innerhalb des Waschwassers zwischen den Elektroden (A, B) während einer Phase des Waschprozesses, wobei der Stromfluss den Kondensator (Co) lädt;
- Mittel (*µ*P) zum Messen der Zeit, welche erforderlich ist, um den Kondensator (Co) mittels des Stromflusses zu laden;
- Mittel (*µ*P) zum Berechnen des spezifischen Wasserwiderstands in indirekter Weise und als Funktion der Zeit, welche zum Aufladen des Kondensators (Co) mittels des Stromflusses erforderlich ist und als Funktion der Eigenschaften des Waschprozesses und zum Messen der gewünschten Wassereigenschaften daraus.

6. Waschmaschine nach Anspruch 5,
**dadurch gekennzeichnet, dass** die Messmittel eine Mikrosteuerung (*µ*P) umfassen.

7. Waschmaschine nach Anspruch 5,
**dadurch gekennzeichnet, dass** die Berechnungs- und Messmittel eine Mikrosteuerung (*µ*P) umfassen.

8. Waschmaschine nach Anspruch 6 oder 7,
**dadurch gekennzeichnet, dass** die Mikrosteuerung (*µ*P) in Fuzzy-Logic programmiert ist.

9. Waschmaschine nach Anspruch 5,
**dadurch gekennzeichnet, dass** die Mittel zur Entladung des Kondensators (Co) einen Transistor (Q) umfassen.

10. Waschmaschine nach Anspruch 6 oder 7,
**dadurch gekennzeichnet, dass** an die Mikrosteuerung (*µ*P) ein mit einem Anschluss des Kondensators (Co) verbundener Eingang (INP) und ein Ausgang (OUT) vorgesehen ist.

11. Waschmaschine nach Anspruch 10,
**dadurch gekennzeichnet, dass** der Ausgang (OUT) mit der Steuerelektrode des Transistors (Q) verbunden ist.

12. Waschmaschine nach Anspruch 5,
**dadurch gekennzeichnet, dass** eine der Elektroden (A) durch die metallische Kammer der Waschmaschine oder durch einen Wasserheizwiderstand oder durch den Körper eines Wassertemperatursensors dargestellt wird.

13. Waschmaschine nach Anspruch 5,
**dadurch gekennzeichnet, dass** wenigstens eine der Elektroden (B) elektrisch isoliert und physikalisch beabstandet ist von metallischen Teilen der Waschmaschine und von der anderen Elektrode (A).

14. Waschmaschine nach Anspruch 5,
**dadurch gekennzeichnet, dass** eine dritte Elektrode (C) vorgesehen ist, welche weit entfernt von den beiden Elektroden (A, B) angeordnet ist.

15. Waschmaschine nach Anspruch 5,
**dadurch gekennzeichnet, dass** eine der Elektroden (B) durch ein metallisches Verbindungsstück, welches zwischen zwei flexiblen Rohren, die aus elektrisch isolierendem Material bestehen und einen Teil des Waschmittelrückgewinnungskreislaufs sind, eingesetzt ist, gebildet ist.

## Revendications

1. Procédé permettant de mesurer, pendant une opération de lavage, la dureté du liquide de lavage utilisé dans une machine à laver, la machine comprenant une chambre de lavage et un dispositif de mesure qui comprend au moins une première et une deuxième électrode (A, B) en contact avec l'eau, le procédé étant **caractérisé par** les opérations suivantes :
a) mettre lesdites électrodes (A, B) en contact avec le liquide de lavage et dans le circuit de charge d'un condensateur (Co) ;
b) faire décharger ledit condensateur (Co) ;
c) faire passer un courant à l'intérieur du liquide de lavage entre lesdites électrodes (A, B), afin de charger ledit condensateur (Co) ;
d) mesurer le temps de charge du condensateur (Co) ;
e) déterminer la valeur de la dureté du liquide de lavage d'une manière indirecte, en fonction :
- du temps nécessaire pour charger ledit condensateur (Co) au moyen dudit courant,
- de la caractéristique de l'opération de lavage.

2. Procédé permettant de mesurer, pendant une opération de lavage, le degré de saleté du liquide de lavage utilisé dans une machine à laver, la machine comprenant une chambre de lavage et un dispositif de mesure qui comprend au moins une première et une deuxième électrode (A, B) en contact avec l'eau, le procédé étant **caractérisé par** les opérations suivantes :
a) mettre lesdites électrodes (A, B) en contact avec le liquide de lavage et dans le circuit de charge d'un condensateur (Co) ;
b) faire décharger ledit condensateur (Co) ;
c) faire passer un courant à l'intérieur du liquide de lavage entre lesdites électrodes (A, B), afin de charger ledit condensateur (Co) ;
d) mesurer le temps de charge du condensateur (Co) ;
e) déterminer la valeur de le degré de saleté du liquide de lavage d'une manière indirecte, en fonction
- du temps nécessaire pour charger ledit condensateur (Co) au moyen dudit courant,
- de la caractéristique de l'opération de lavage.

3. Procédé permettant de mesurer, pendant une opération de lavage, la concentration en détergents du liquide de lavage utilisé dans une machine à laver, la machine comprenant une chambre de lavage et un dispositif de mesure qui comprend au moins une première et une deuxième électrode (A, B) en contact avec l'eau, le procédé étant **caractérisé par** les opérations suivantes :
a) mettre lesdites électrodes (A, B) en contact avec le liquide de lavage et dans le circuit de charge d'un condensateur (Co) ;
b) faire décharger ledit condensateur (Co) ;
c) faire passer un courant à l'intérieur du liquide de lavage entre lesdites électrodes (A, B), afin de charger ledit condensateur (Co) ;
d) mesurer le temps de charge du condensateur (Co) ;
e) déterminer la valeur de la concentration en détergents du liquide de lavage d'une manière indirecte, en fonction :
- du temps nécessaire pour charger ledit condensateur (Co) au moyen dudit courant,
- de la caractéristique de l'opération de lavage.

4. Procédé selon la revendication 1, 2 ou 3, **caractérisé en ce qu'**au moins les opérations d) et f) sont effectuées par un microrégisseur (µP) programmé selon des techniques de logique floue.

5. Machine à laver, notamment machine à laver le linge, comprenant une chambre de lavage et un dispositif qui sert à mesurer les caractéristiques de l'eau de lavage pendant une opération de lavage, comme par exemple le degré de saleté de l'eau, la dureté de l'eau, la concentration en détergents de l'eau,
**caractérisée en ce que** ledit dispositif comprend :
- au moins deux électrodes (A, B) en contact avec l'eau de lavage et insérées dans le circuit de charge d'un condensateur (Co) ;
- un moyen servant à décharger ledit condensateur (Co) ;
- un moyen (E) qui, pendant une phase du processus de lavage, fait passer un courant dans ladite eau de lavage entre lesdites électrodes (A, B), qui charge ledit condensateur (Co) ;
- un moyen (µP) servant à mesurer le temps nécessaire pour charger ledit condensateur (Co) au moyen dudit courant ;
- un moyen (µP) servant à calculer, de manière indirecte, en fonction du temps nécessité pour la charge dudit condensateur (Co) au moyen dudit courant et en fonction des caractéristiques de l'opération de lavage, la résistivité de l'eau, et à mesurer, à partir de cette dernière, les caractéristiques voulues de l'eau.

6. Machine à laver selon la revendication 5, **caractérisée en ce que** ledit moyen de mesure comprend un microrégisseur (µP).

7. Machine à laver selon la revendication 5, **caractérisée en ce que** ledit moyen de calcul et de mesure comprend un microrégisseur (µP).

8. Machine à laver selon la revendication 6 ou 7, **caractérisée en ce que** ledit microrégisseur (µP) est programmé selon les techniques de la logique floue.

9. Machine à laver selon la revendication 5, **caractérisée en ce que** ledit moyen servant à décharger ledit condensateur (Co) comprend un transistor (Q).

10. Machine à laver selon la revendication 6 ou 7, **caractérisée en ce que** ledit microrégisseur (µP) comporte une borne d'entrée (INP) connectée à une partie dudit condensateur (Co), et une borne de sortie (OUT).

11. Machine à laver selon la revendication 10, **caractérisée en ce que** la borne de sortie (OUT) est connectée à l'électrode de commande dudit transistor (Q).

12. Machine à laver selon la revendication 5, **caractérisée en ce que** l'une desdites électrodes (A) est constituée par la chambre métallique de la machine à laver, ou bien par une résistance de chauffage de l'eau, ou bien par le corps d'un capteur de température de l'eau.

13. Machine à laver selon la revendication 5, **caractérisée en ce qu'**au moins l'une desdites électrodes (B) est électriquement isolée et est matériellement écartée des parties métalliques de la machine à laver et de l'autre électrode (A).

14. Machine à laver selon la revendication 5, **caractérisée en ce qu'**une troisième électrode (C) est prévue, laquelle est disposée de façon à être éloignée des deux dites électrodes (A, B).

15. Machine à laver selon la revendication 5, **caractérisée en ce que** l'une (B) desdites électrodes est constituée par un joint métallique inséré entre deux tubes souples, faits en un matériau électriquement isolé, constituant une partie d'un circuit de récupération de détergents.
